(19) Europäisches Patentamt / European Patent Office / Office européen des brevets

(11) **EP 2 008 357 B1**

(12) **FASCICULE DE BREVET EUROPEEN**

(45) Date de publication et mention
de la délivrance du brevet:
**19.12.2018 Bulletin 2018/51**

(21) Numéro de dépôt: **07731323.7**

(22) Date de dépôt: **19.04.2007**

(51) Int Cl.:
**H02M 1/08** *(2006.01)*

(86) Numéro de dépôt international:
**PCT/FR2007/000659**

(87) Numéro de publication internationale:
**WO 2007/122322 (01.11.2007 Gazette 2007/44)**

(54) **CIRCUIT DE COMMUTATION POUR LA MISE EN SERIE DES IGBT**

SCHALTNETZWERK ZUR REIHENIMPLEMENTIERUNG VON IGBT-TRANSISTOREN

SWITCHING CIRCUIT FOR THE SERIES IMPLEMENTATION OF IGBT TRANSISTORS

(84) Etats contractants désignés:
**AT BE BG CH CY CZ DE DK EE ES FI FR GB GR
HU IE IS IT LI LT LU LV MC MT NL PL PT RO SE
SI SK TR**

(30) Priorité: **20.04.2006 FR 0603516**

(43) Date de publication de la demande:
**31.12.2008 Bulletin 2009/01**

(73) Titulaire: **GE Energy Power Conversion France
SAS
91300 Massy (FR)**

(72) Inventeur: **GOLLENTZ, Bernard
68360 Soultz (FR)**

(74) Mandataire: **Serjeants LLP
Dock
75 Exploration Drive
Leicester, LE4 5NU (GB)**

(56) Documents cités:
EP-A2- 0 458 511      DE-A1- 1 413 526
DE-A1- 4 335 857

- MELITO M ET AL: "SWITCHING BALANCEMENT
OF SERIES CONNECTED INSULATED GATE
DEVICES BYGATE CONTROL STRATEGY" EPE
'97. 7TH. EUROPEAN CONFERENCE ON POWER
ELECTRONICS AND APPLICATIONS.
TRONDHEIM, SEPT. 8 - 10, 1997, EPE .
EUROPEAN CONFERENCE ON POWER
ELECTRONICS AND APPLICATIONS,
BRUSSELS, EPE ASSOCIATION, B, vol. VOL. 4
CONF. 7, 8 septembre 1997 (1997-09-08), pages
4034-4038, XP000768129 ISBN: 90-75815-02-6
- BEOM-SEOK SEO ET AL: "Synchronization on
the points of turn-off time of series-connected
power semiconductor devices using Miller
effect" SIGNAL PROCESSING AND SYSTEMS
CONTROL, INTELLIGENT SENSORS AND
INSTRUMENTATION. SAN DIEGO, NOV. 9 - 13,
1992, PROCEEDINGS OF THE INTERNATIONAL
CONFERENCE ON INDUSTRIAL
ELECTRONICS,CONTROL, INSTRUMENTATION
AND AUTOMATION (IECON), NEW YORK, IEEE,
US, vol. VOL. 3 CONF. 18, 9 novembre 1992
(1992-11-09), pages 325-329, XP010060676 ISBN:
0-7803-0582-5

## Description

La présente invention concerne un circuit de commutation du type comportant deux transistors de puissance montés en série et un circuit d'excitation de chaque transistor propre à obtenir une commutation simultanée des deux transistors

Les moteurs à courant alternatif sont couramment alimentés à partir d'un bus d'alimentation en courant continu aux bornes desquelles sont connectées les différentes phases des moteurs par l'intermédiaire d'un variateur de fréquence, constitué d'organes de commutation dont l'état est piloté par une électronique de commande adaptée.

De telles électroniques de commande sont par exemple discutées dans les documents EP 0458511 et DE 1413526.

Pour les moteurs d'entraînement de pompe ou de compresseur très puissants, notamment pour l'exploitation pétrolière, de très fortes puissances électriques doivent circuler au travers des organes de commutation assurant l'alimentation du moteur.

Les organes sont constitués par des transistors de type IGBT. Pour faire des variateurs de fréquence des moteurs très puissants, il convient de monter en série deux transistors de type IGBT pour assurer chaque commutation, un unique transistor ne permettant pas d'interrompre la circulation du courant pour des tensions très élevées à ces bornes.

Les deux transistors ainsi connectés en série doivent être commandés avec une synchronisation parfaite afin que ceux-ci correspondent fonctionnellement à un unique transistor. Les erreurs de synchronisation entre les deux transistors conduisent à ce que la tension soit supportée par seulement un des transistors, ce qui peut occasionner sa destruction.

Compte tenu des tolérances de fabrication des transistors et de la précision de l'électronique de commande, la synchronisation du fonctionnement des transistors est délicate à assurer. Des solutions électroniques de commande très sophistiquées ont été développées. Ces solutions nécessitent la mise en oeuvre de circuits intégrés spécifiques qui sont très coûteux.

Par ailleurs, on connaît une technique de protection des transistors désignés couramment en anglais par l'expression « active clamping ».

Suivant cette solution, les transistors sont associés entre la grille de commande et une borne de conduction à une diode zener avec une résistance montée en inverse qui, lorsque la tension est trop forte entre les bornes de conduction du transistor permet de ramener le transistor vers son état passant et ainsi limiter la tension à ses bornes.

Cette technique nécessite des marges d'allumage des transistors très élevées et impose d'utiliser des diodes zener résistantes et relativement précises.

On a déjà proposé des solutions à ces difficultés.

Par exemple, dans le document DE 43 35 857, on génère un signal correctif qui commande un retard dans la commutation d'un des transistors. Ce document fait l'objet du préambule de la revendication 1.

L'article MELITO, "SWITCHING BALANCEMENT OF SERIES CONNECTED INSU LATE GATE DEVICES BY GATE CONTROL STRATEGY", EPE'97, 7TH EURO- PEAN CONFERENCE ON POWER ELECTRONICS AND APPLICATIONS, TROND- HEIM, SEPT. 8-10, 1997 décrit un agencement dans lequel le circuit de commande de l'un des transistors en série est remplacé par un agencement à générateur de courant et puits de courant.

Dans le document BEOM-SEOK, "SYNCHCRONISATION ON THE POINTS OF TURN-OFF TIME OF SERIES-CONNECTED POWER SEMICONDUCTOR DEVICES USING MILLER EFFECT", SIGNAL PROCESSING AND SYSTEM CONTROL1 INTELLIGENT SENSORS AND INSTRUMENTATION, SAN DIEGO, NOV. 9-13, 1992, on utilise un circuit amortisseur pour commander les circuits de commande des transistors.

Dans ces documents, les signaux correctifs sont toujours affectés aux circuits de commande des transistors et non aux transistors eux-mêmes. Il en résulte des montages complexes, qui de ce fait présentent l'inconvénient de constantes de temps relativement importantes.

L'invention a pour but de proposer une solution peu coûteuse au problème de la synchronisation de deux transistors montés en série.

A cet effet, l'invention a tout d'abord pour objet un circuit de commutation du type précité, comportant des moyens d'élaboration d'un courant correctif de commande d'un transistor à commande corrigée parmi les deux transistors, en fonction de la différence d'évolution temporelle de la tension aux bornes de conduction des deux transistors montés en série, et des moyens d'application dudit courant à l'électrode de grille du transistor à commande corrigée, le circuit comportant deux condensateurs reliés aux bornes de conduction des deux transistors, les deux condensateurs étant reliés en série aux bornes de conduction extrêmes des deux transistors, et les moyens d'élaboration du courant correctif comportent des moyens de prélèvement du courant correctif de commande, au point milieu des deux condensateurs, et au moins à la grille d'un transistor un circuit d'inhibition du courant correctif appliqué au transistor à commande corrigée pour inhiber la correction lors d'un court-circuit de l'autre transistor.

Ainsi, dans l'invention, le courant correctif agit sur le fonctionnement interne du transistor, qui est par ailleurs commandé par un système de commande conventionnel.

Suivant des modes particuliers de réalisation, le circuit de commutation comporte l'une ou plusieurs des caractéristiques définies dans les revendications dépendantes.

L'invention a également pour objet un variateur de fréquence pour moteur à courant alternatif comportant au moins un circuit de commutation tel que décrit ci-dessus.

L'invention sera mieux comprise à la lecture de la description qui va suivre, donnée uniquement à titre d'exemple et faite en se référant aux dessins, sur lesquels :

- la figure 1 est une vue schématique d'un variateur de vitesse alimentant un moteur à courant alternatif. ;
- la figure 2 est un schéma d'un circuit de commutation du variateur de la figure 1 ;
- les figures 3 et 4 sont des courbes illustrant le fonctionnement du circuit de commutation de la figure 2 ; et
- les figures 5, 6 et 7 sont des schémas de variantes de réalisation d'un circuit de commutation.

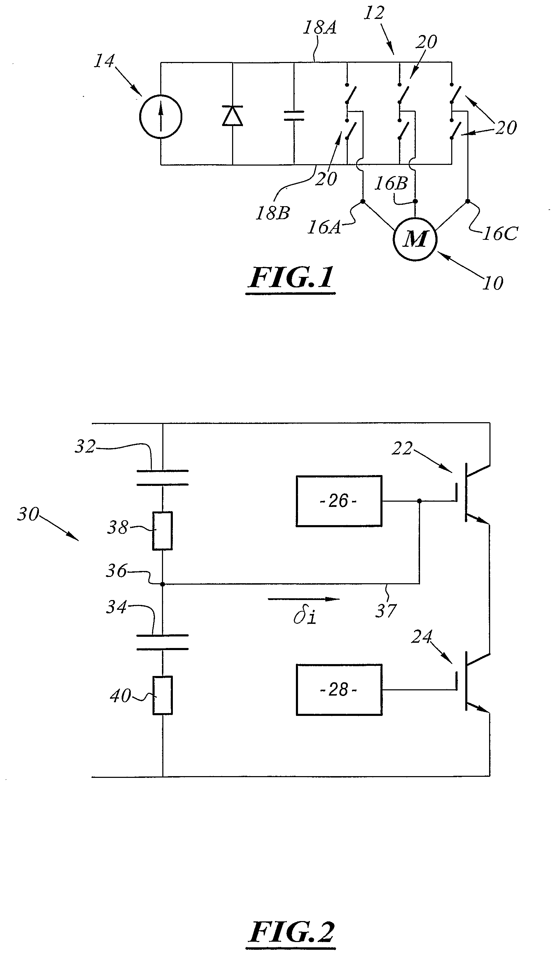

Les modes de réalisation représentés dans les figures 2, 5 et 6 ne font pas partie de l'invention mais représentent des éléments de l'état technique qui sont utiles à la compréhension de l'invention.

Sur la figure 1, un moteur 10 à courant alternatif est alimenté par un variateur de vitesse 12 tel qu'illustré. Ce variateur est relié sur un bus 14 d'alimentation en courant continu. Par exemple, trois pôles 16A, 16B, 16C du moteur sont reliés chacun à une borne 18A, 18B du bus d'alimentation en courant continu par un circuit de commutation 20. Ainsi, six circuits de commutation 20 sont mis en oeuvre, chacun entre une phase du moteur et une borne du bus. Chaque circuit de commutation est piloté par un circuit de commande non représenté.

L'un des circuits de commutation 20 est représenté en détail sur la figure 2. Il comporte deux transistors 22, 24 de type IGBT reliés en série entre une borne du bus et une phase du moteur. L'électrode de grille de chaque transistor est reliée à un circuit d'excitation 26, 28 respectivement connu en soi.

En outre, le circuit de commutation 20 comporte des moyens 30 d'élaboration d'un signal correctif, ici un courant $\delta i$, de commande d'un transistor à commande corrigée parmi les deux transistors 22, 24, en fonction de la différence d'évolution temporelle de la tension aux bornes de conduction des deux transistors montés en série.

Dans le mode de réalisation illustré sur la figure 2, le transistor à commande corrigée est le transistor 22.

Les moyens 30 d'élaboration du signal correctif comprennent ici deux condensateurs 32, 34 montés en série entre les bornes de conduction extrêmes des deux transistors 22, 24.

Le point milieu 36 des deux condensateurs est relié à la grille du condensateur à commande corrigée 22 par un conducteur 37 d'injection d'un courant de correction.

Suivant un mode de réalisation avantageux, et tel qu'illustré sur la figure 2, chaque condensateur 32, 34 est associé en série à une résistance 38, 40 améliorant la stabilité du fonctionnement.

Les condensateurs sont identiques et ont par exemple une capacité comprise entre 100 pF et 10 nF. De même, les deux résistances sont identiques et ont une résistance comprise entre 1 $\Omega$ et 100 $\Omega$.

Il résulte des connexions du circuit illustré sur la figure 2 que le courant $\delta i$ injecté depuis le point milieu 36 des deux condensateurs vers la grille du transistor à commande corrigée 22 et correspondant au signal correctif est égale à $\delta i = C \dfrac{d}{dt}\left(V_{32} - V_{34}\right)$ où $V_{32}$ et $V_{34}$ sont les tensions aux bornes des condensateurs 32, 34, C est la capacité des deux condensateurs ; et $\dfrac{d}{dt}$ désigne la dérivée par rapport au temps.

Ainsi, en fonctionnement, lorsqu'une différence des dérivés de la tension par rapport au temps aux bornes des deux transistors 22, 24 se produit pendant la commutation, une dissymétrie dans la charge ou la décharge des condensateurs apparaît. Ainsi, un courant $\delta i$ est produit et est réinjecté dans la grille du transistor à commande corrigée 22 corrigeant ainsi le courant qui le traverse et modifiant de manière corrélative la charge du condensateur monté en parallèle.

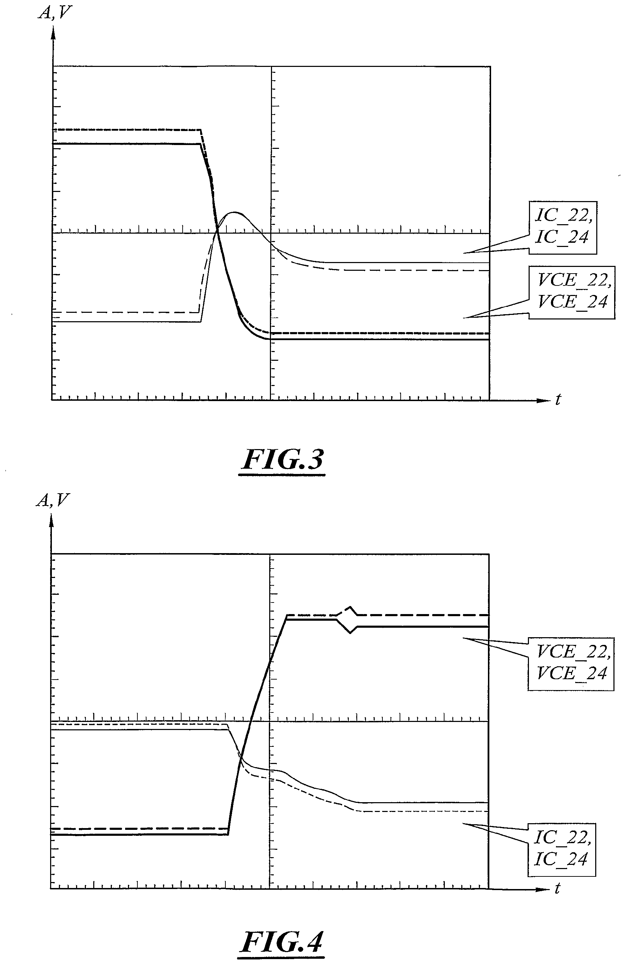

Un exemple est illustré sur les figures 3 et 4 montrant respectivement la commutation vers l'état passant et vers l'état bloqué d'un circuit de commutation.

On constate sur ces deux figures que les tensions aux bornes des deux transistors représentés en trait continu gras pour le transistor 22 et en pointillés longs pour le transistor 24 chutent ou augmentent mais qu'elles restent sensiblement égales pendant toute la phase de mise en circulation ou d'arrêt du courant. Le courant, illustré en pointillés courts pour le transistor 22 et en trait continu fin pour le transistor 24, passe d'une valeur minimale, à une valeur stationnaire supérieure après un passage par une valeur extrême ou d'une valeur stationnaire à une valeur inférieure. Les deux transistors étant en série, les courants circulants sont sensiblement identiques.

Ainsi, un circuit passif simple est fourni qui permet d'accélérer ou de ralentir la commutation du transistor à commande corrigée de manière à établir de manière forcée une répartition de la tension entre les deux transistors pendant la commutation.

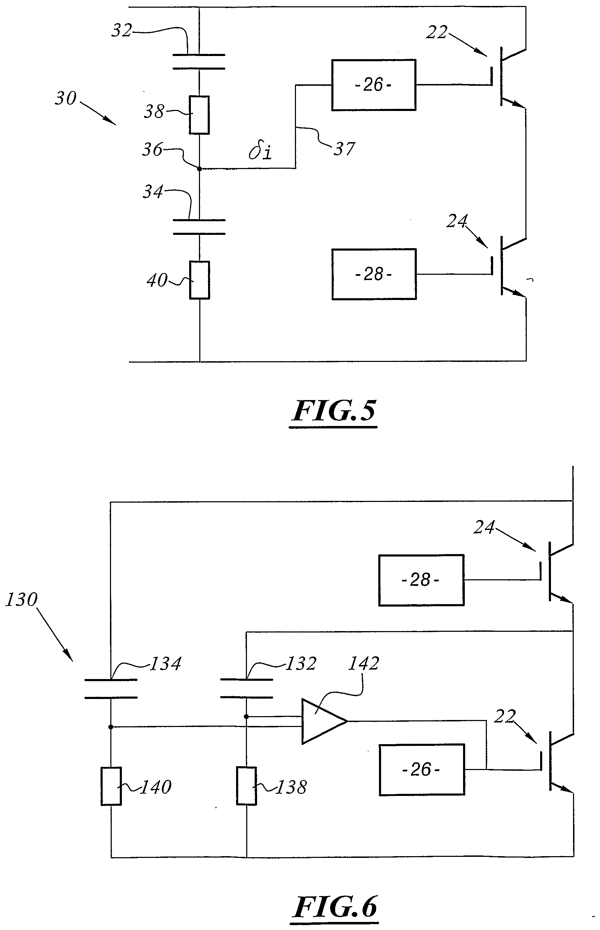

Suivant encore une autre variante illustrée sur la figure 5, le courant correctif $\delta i$ est introduit dans le circuit 26 d'excitation du transistor à commande corrigée 22 et n'est pas appliqué directement à la grille du transistor à commande corrigé 22.

Dans ce mode de réalisation, le circuit d'excitation 26 est adapté pour modifier le signal d'excitation adressé à la grille du transistor à commande corrigée en fonction du courant correctif reçu $\delta i$. En particulier, le courant correctif reçu est filtré et amplifié, afin d'être ajouté au signal de commande produit comme connu en soi par le circuit d'excitation 26.

Un autre mode de réalisation d'un circuit de commutation est illustré sur la Figure 6 où l'on retrouve les deux transistors 22, 24 montés en série et chacun associé à un circuit d'excitation 26, 28 respectivement.

Dans ce mode de réalisation, le transistor à commande corrigée 22 est relié à la source du transistor 24, c'est-à-dire que les transistors sont inversés par rapport au mode de réalisation des Figures 1 et 5.

Des moyens 130 d'élaboration d'un courant correctif δi de commande pour le transistor 22 sont également prévus.

Ceux-ci comportent un condensateur 132 monté entre les deux bornes de conduction du transistor à commande corrigée 22 ainsi qu'un second condensateur 134 monté en parallèle entre les bornes conductrices extrêmes des deux transistors 22, 24.

Chaque condensateur 132, 134 est monté en série avec une résistance 138, 140. Ces résistances sont connectées entre les collecteurs des transistors 22 et 24 et une armature du condensateur correspondant.

Chaque armature des condensateurs 132, 134 reliée à une résistance 138, 140 est connectée à l'entrée d'un calculateur analogique 142 propre à établir une combinaison linéaire entre les signaux reçus en entrée.

La sortie du calculateur 142 est reliée directement à la grille du transistor à commande corrigée 22. En variante, cette sortie est reliée au circuit d'excitation 26.

Le calculateur 142 est adapté pour calculer un courant de correction $\delta i = C \dfrac{d}{dt}(V_{132} - V_{134})$ en négligeant la valeur des résistances 138, 140.

On comprend que dans ce mode de réalisation également, le signal de commande du transistor 22 est modifié en fonction des tensions aux bornes des deux condensateurs 132, 134. Ces tensions sont directement liées aux tensions aux bornes des transistors 22, 24. Ainsi, en cas de différence dans les tensions aux bornes des transistors, une différence comparable est constatée aux bornes des condensateurs et un courant correctif représentatif de cette différence est appliqué au transistor 22, corrigeant ainsi la différence de tension aux bornes des transistors.

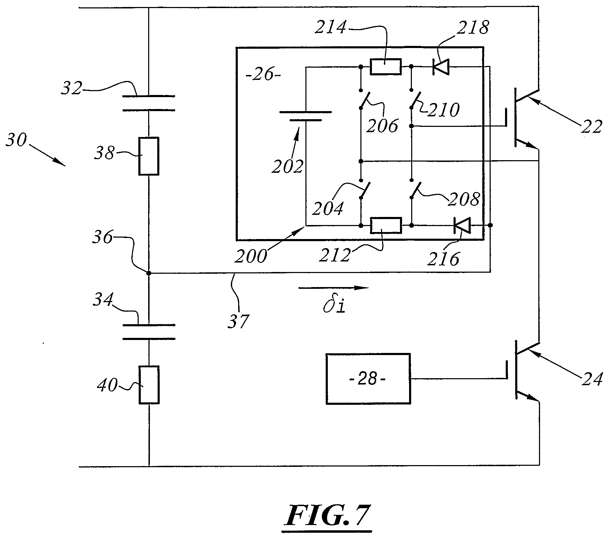

Sur la Figure 7 est représenté un perfectionnement au mode de réalisation de la Figure 1.

Ainsi, les éléments identiques sont désignés par les mêmes numéros de référence.

Ce mode de réalisation comporte un étage intermédiaire 200 d'inhibi-tion du courant correctif permettant une redondance des transistors IGBT et un fonctionnement de circuit de commutation lorsque l'un des transistors IGBT est défaillant et bloqué à l'état passant.

En particulier, cet étage 200 est interposé entre le point milieu des deux condensateurs 32, 34 suivant la ligne 37 d'injection du courant de correction et la grille du transistor 22 à commande corrigée.

Ce dispositif comporte une source de tension 202 par exemple de 15 Volts et quatre organes de commutation de commande chacun commandé pour appliquer une tension de plus ou moins 15 Volts à la grille du transistor 22 pour permettre la poursuite du fonctionnement.

Ainsi, deux organes de commutation 204, 206 sont connectés respectivement aux bornes de la source de tension 202 et au collecteur du transistor 22.

De même, deux organes de commutation 208, 210 relient les bornes de la source de tension à la grille du transistor 22 par l'intermédiaire de deux résistances 212, 214. Une borne de chaque organe de commutation 208, 210 reliée à la résistance respectivement 212, 214 est connectée à la grille du transistor 22.

Ainsi, la source de tension 202, les organes de commutation 208, 210, 212, 214 et les résistances 212, 214 forment le circuit d'excitation 26 commandant le transistor 22. Le circuit d'excitation 26 est relié au point milieu 36 défini entre les deux condensateurs 32, 34 par deux diodes 216, 218.

Plus précisément, chaque organe de commutation 208, 210 est relié directement au point milieu 36 par l'intermédiaire d'une diode 216, 218, connectée entre un organe de commutation et la résistance associée. L'étage 200 comporte en outre une unité de pilotage des organes de commutation 204 à 210 non représentée.

A la mise en conduction du circuit de commutation, les seuls organes de commutation 204 et 210 sont passants. La tension de commande à la grille est égale à $V_{GE}$ = 15 volts et le courant de grille issu du circuit d'excitation 26 circule au travers de la résistance 214.

A la fermeture du circuit de commutation, les transistors 206, 208 sont mis en conduction. La tension de commande à la grille est alors égale à $V_{GE}$ = - 15 volts et le courant de grille issu du circuit d'excitation 26 passe au travers de la résistance 212.

L'utilisation des diodes 216, 218 dans le circuit de retour de δi assure que les caractéristiques de mise en conduction et d'ouverture du transistor à commande corrigée 22 soit seulement modifiées dans le cas où le transistor à commande corrigée 22 commute plus lentement que le transistor associé 24 en fonctionnement normal.

Si pendant un état de défaut, le transistor 24 est court-circuité, la présence des diodes 216, 218 permet de découpler la commutation du transistor 22 des effets résultant du court-circuit établi aux bornes du transistor 24.

Pour compenser pendant le fonctionnement normal le fait que la commutation du transistor à commande corrigée 22 ne peut pas être faite plus lentement pour correspondre à celle du transistor 24, les résistances 212 et 214 sont sélectionnées de sorte que les commutations du transistor 24 soient plus rapides que celles du transistor 22. De manière alternative, des retards sont employés dans les portes du transistor à commande corrigée 22 par rapport à celle du transistor 24 pour une compensation améliorée.

## Revendications

1. Circuit de commutation comportant deux transistors de puissance (22, 24) montés en série, un circuit (26, 28) d'excitation de chaque transistor propre à obtenir une commutation simultanée des deux transistors, des moyens (30) d'élaboration d'un courant correctif (δi) de commande d'un transistor à commande corrigée (22) parmi les deux transistors (22, 24), en fonction de la différence d'évolution temporelle de la tension aux bornes de conduction des deux transistors (22, 24) montés en série, et des moyens (37) d'application dudit courant à l'électrode de grille du transistor à commande corrigée (22), **caractérisé en ce qu'**il comporte deux condensateurs (32, 34 ; 132, 134) reliés aux bornes de conduction des deux transistors (22, 24), les deux condensateurs (32, 34) étant reliés en série aux bornes de conduction extrêmes des deux transistors (22, 24), et les moyens (30) d'élaboration du courant correctif (δi) comportent des moyens (37) de prélèvement du courant correctif (δi) de commande, au point milieu (36) des deux condensateurs (32, 34), et **en ce qu'**il comporte au moins à la grille d'un transistor (22) un circuit (200) d'inhibition du courant correctif (δi) appliqué au transistor à commande corrigée (22) pour inhiber la correction lors d'un court-circuit de l'autre transistor (24).

2. Circuit de commutation selon la revendication 1, **caractérisé en ce qu'**au moins un condensateur (32, 34 ; 132, 134) est monté en série avec une résistance (38, 40 ; 138, 140).

3. Circuit de commutation selon l'une quelconque des revendications précédentes, **caractérisé en ce qu'**il comporte des moyens (36 ; 37) pour appliquer le courant correctif (δi) de commande directement à l'électrode de grille du transistor à commande corrigée (22).

4. Circuit de commutation selon l'une quelconque des revendications précédentes, **caractérisé en ce qu'**il comporte des moyens (37) pour ajouter le courant correctif (δi) de commande au signal de commande produit par le circuit (26) d'excitation du transistor à commande corrigée.

5. Variateur de fréquence d'un moteur à courant alternatif comportant au moins un circuit de commutation selon l'une quelconque des revendications précédentes.

## Patentansprüche

1. Kommutierungsschaltkreis aufweisend zwei Leistungstransistoren (22, 24), die in Reihe geschaltet sind, einen Erregerschaltkeis (26, 28) für jeden Transistor, der eingerichtet ist, um eine simultane Kommutation der zwei Transistoren zu erhalten, Mittel (30) zur Erzeugung eines Korrekturstromes (δi) der Steuerung eines Transistors mit korrigierter Steuerung (22) unter den zwei Transistoren (22, 24) als Funktion der Differenz der zeitlichen Entwicklung der Spannung an den Leitungsanschlüssen der beiden in Reihe geschalteten Transistoren (22, 24), und Mitteln (37) zum Aufbringen dieses Stromes an der Steuerelektrode des Transistors mit korrigierter Steuerung (22), **dadurch gekennzeichnet, dass** er zwei Kondensatoren (32, 34; 132, 134) aufweist, die mit den Leitungsanschlüssen der zwei Transistoren (22, 24) verbunden sind, wobei die zwei Kondensatoren (32, 34) in Reihe mit den äußeren Leitungsanschlüssen der beiden Transistoren (22, 24) verbunden sind und die Mittel (30) zur Erzeugung des Korrekturstromes (δi) Mittel (37) zur Entnahme des Korrekturstromes (δi) der Steuerung am Mittelpunkt (36) der zwei Kondensatoren (32, 34) aufweisen, und dass er zumindest an der Steuerelektrode eines Transistors (22) einen Blockadeschaltkreis (200) des Korrekturstromes (δi), der auf den Transistor mit korrigierter Steuerung (22) aufgebracht wird, aufweist, um die Korrektur bei einem Kurzschluss des anderen Transistors (24) zu blockieren.

2. Kommutierungsschaltkreis nach Anspruch 1, **dadurch gekennzeichnet, dass** wenigstens ein Kondensator (32, 34; 132, 134) in Reihe mit einem Widerstand (38, 40; 138, 140) geschaltet ist.

3. Kommutierungsschaltkreis nach irgendeinem der vorhergehenden Ansprüche, **dadurch gekennzeichnet, dass** er Mittel aufweist (36; 37) zum Aufbringen des Korrekturstromes (δi) der Steuerung unmittelbar auf die Steuerelektrode des Transistors mit korrigierter Steuerung (22).

4. Kommutierungsschaltkreis nach irgendeinem der vorhergehenden Ansprüche, **dadurch gekennzeichnet, dass** er Mittel (37) aufweist, um den Korrekturstrom (δi) der Steuerung zum Steuersignal hinzuzufügen, das durch den Erregerschaltkreis (26) des Transistors mit korrigierter Steuerung erzeugt wird.

5. Frequenzwandler eines Wechselstrommotors aufweisend wenigstens einen Kommutierungsschaltkreis nach irgendeinem der vorhergehenden Ansprüche.

**Claims**

1. Switching circuit comprising two series-mounted power transistors (22, 24), an excitation circuit (26, 28) for each transistor able to obtain simultaneous switching of both transistors, means (30) for producing a controlling corrective current ($\delta i$) for a corrected-control transistor (22) of the two transistors (22, 24) as a function of the difference in temporal development of the voltage at the conduction terminals of the two series-mounted transistors (22, 24), and means (37) for applying said current to the gate electrode of the corrected-control transistor (22), **characterised in that** it comprises two capacitors (32, 34; 132, 134) connected to the conduction terminals of the two transistors (22, 24), the two capacitors (32, 34) being connected in series to the end conduction terminals of the two transistors (22, 24), and the means (30) for producing corrective current ($\delta 1$) comprising means (37) for sampling the controlling corrective current ($\delta 1$) at the middle point (36) of the two capacitors (32, 34), and **in that** it comprises, at least at the gate of one transistor (22), a circuit (200) inhibiting the corrective current ($\delta 1$) applied to the corrected-control transistor (22) in order to inhibit the correction during a short-circuit of the other transistor (24).

2. Switching circuit according to claim 1, **characterised in that** at least one capacitor (32, 34; 132, 134) is mounted in series with a resistor (38, 40; 138, 140).

3. Switching circuit according to one of the preceding claims, **characterised in that** it comprises means (36, 37) for applying the controlling corrective current ($\delta 1$) directly to the gate electrode of the corrected-control transistor (22).

4. Switching circuit according to any of the preceding claims, **characterised in that** it comprises means (37) for adding the controlling corrective current ($\delta 1$) to the control signal produced by the excitation circuit (26) of the corrected-control transistor.

5. Frequency converter of an alternating current motor comprising at least one switching circuit according to any of the preceding claims.

**FIG.1**

**FIG.2**

A,V

IC_22,
IC_24

VCE_22,
VCE_24

t

**_FIG.3_**

A,V

VCE_22,
VCE_24

IC_22,
IC_24

t

**_FIG.4_**

**FIG.5**

**FIG.6**

**FIG.7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0458511 A
- DE 1413526

- DE 4335857

**Littérature non-brevet citée dans la description**

- **MELITO.** SWITCHING BALANCEMENT OF SERIES CONNECTED INSU LATE GATE DEVICES BY GATE CONTROL STRATEGY. *EPE'97, 7TH EURO-PEAN CONFERENCE ON POWER ELECTRONICS AND APPLICATIONS,* 08 Septembre 1997

- **BEOM-SEOK.** SYNCHCRONISATION ON THE POINTS OF TURN-OFF TIME OF SERIES-CONNECTED POWER SEMICONDUCTOR DEVICES USING MILLER EFFECT. *SIGNAL PROCESSING AND SYSTEM CONTROL1 INTELLIGENT SEN-SORS AND INSTRUMENTATION,* 09 Novembre 1992